# EUROPEAN PATENT APPLICATION

(11) **EP 4 653 881 A1**
(43) Date of publication of application: **26.11.2025**
(21) Application number: 25176779.4
(22) Date of filing: 15.05.2025
(51) Int. Cl.: G01R 19/165

(54) **RAIL-TO-RAIL VOLTAGE DETECTOR INCLUDING MULTIPLE VOLTAGE CONVERTERS**

(30) Priority: 21.05.2024 IN 202441039504
(71) Applicant: NXP USA, Inc., Austin, TX 78735 (US)
(72) Inventor: Kumar, Atul, 5656AG Eindhoven (NL); Singh, Devesh Pratap, 5656AG Eindhoven (NL); Das, Soumyashib, 5656AG Eindhoven (NL); Jain, Saurabh, 5656AG Eindhoven (NL)
(74) Representative: Miles, John Richard

(57) **Abstract**

A voltage detector for measuring a voltage between voltage rails including first and second voltage to current (V2I) converters, a current converter, and a controller. The controller enables the first V2I converter when a selected voltage is between the first voltage rail and an intermediate voltage and enables the second V2I converter when the selected voltage is between the intermediate voltage and the second voltage rail. Each V2I converter converts the selected voltage into an output current when enabled. The current converter converts the output current into a measured value and the controller converts the measured value into an output voltage. The controller may enable either V2I converter and select a reference voltage for determining a reference value, then select an input voltage for determining an input value using the enabled V2I converter, and then compare the reference and input values for determining which V2I converter provides a correct result.

## Description

### BACKGROUND

### FIELD

The present disclosure relates in general to voltage measurement, and more particularly to a system and method of providing rail-to-rail voltage detection using multiple voltage converters for accurately measuring or validating on-chip voltages.

### DESCRIPTION OF THE RELATED ART

Multiple instances of clocking and reference generation subsystems may be included for the next generation of large system-on-chip (SoC) configurations. In such subsystembased architectures, there may be many instances of the same or similar functional blocks on the SoC which need to be tested and validated. Validation effort and test time using automatic test equipment (ATE) during production may increase proportionally with increased integration. Several time-based solutions with small footprints provided on-chip are known yet are only accurate within limited voltage ranges and suffer from significant rail-to-rail nonlinearities. Linearity of such solutions may be improved by adding analog components, such as constant transconductance stages or analog comparators and the like. Such solutions, however, consume a significant amount of valuable semiconductor chip area making them less suitable for a distributed on-chip solution.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified block diagram of a semiconductor chip or integrated circuit (IC) coupled to a test controller which is further coupled to a memory, in which the IC incorporates one or more analog circuits each including a rail-to-rail voltage detector implemented according to one embodiment.
FIG. 2 is a simplified block diagram of a voltage detector implemented according to one embodiment that may be used in any up to all of the analog circuits of FIG. 1.
FIG. 3 is a flowchart diagram illustrating operation of the test controller of FIG. 1 performing a read operation of a selected voltage on the IC 100 according to one embodiment.
FIG. 4 is a schematic diagram of a V2I converter implemented according to one embodiment which may be used as any of the V2I converters of any of the VCO's of the corresponding VTC's of FIG. 2.
FIG. 5 is a plot of output frequency FOUT versus input voltage VIN of selected VIN values ranging from GND to VDD (rail-to-rail) of a selected VCO using the V2I converter of FIG. 4 in which the NMOS V2I converter of FIG. 4 is enabled while applying the output current IOUT to a corresponding oscillator of FIG. 2 according to one embodiment.
FIG. 6 is a plot of FOUT versus VIN of selected VIN values ranging from GND to VDD of a selected VCO using the V2I converter of FIG. 4 in which the PMOS V2I converter of FIG. 4 is enabled while applying IOUT to a corresponding oscillator of FIG. 2 according to one embodiment.
FIG. 7 is a plot of FOUT versus VIN of selected VIN values ranging from GND to VDD (rail-to-rail) of a selected VCO while enabling the PMOS V2I converter of the V2I converter of FIG. 4 in a first voltage range and while enabling the NMOS V2I converter of FIG. 4 in a second voltage range.
FIG. 8 is a plot of PMOS and NMOS calibration ranges of FOUT versus VIN ranging from GND to VDD (rail-to-rail) of a selected VCO while applying IOUT to a corresponding oscillator.
FIG. 9 is a flowchart diagram illustrating a calibration procedure for calibrating each of the VTCs of FIG. 2 of the IC of FIG. 1 according to one embodiment.
FIG. 10 is a block diagram illustrating the CAL_PAR store of FIG. 1 configured as a lookup table (LUT) implemented according to one embodiment for storing the calibration parameters.
FIG. 11 is a flowchart diagram illustrating operation of the test controller of FIG. 1 controlling the voltage detector of FIG. 2 incorporating the V2I converter of FIG. 4 for measuring and validating a selected input voltage VIN according to one embodiment.

### DETAILED DESCRIPTION

In order to bring down the cumulative testing time and trim cost, an on-chip solution for detecting (e.g., measuring and validating) on-die voltages is described herein that can be placed within each subsystem to allow parallel testing. Each voltage detector includes multiple voltage converters in order to support the full rail-to-rail input voltage range and thus may be used for monitoring critical voltages and pad input voltages and the like which may vary within the full range of voltages possible in each subsystem. The voltage detector with multiple voltage converters described herein has a relatively small footprint and may be duplicated in each subsystem yet also has sufficient resolution to meet the desired level of accuracy for testing and trimming.

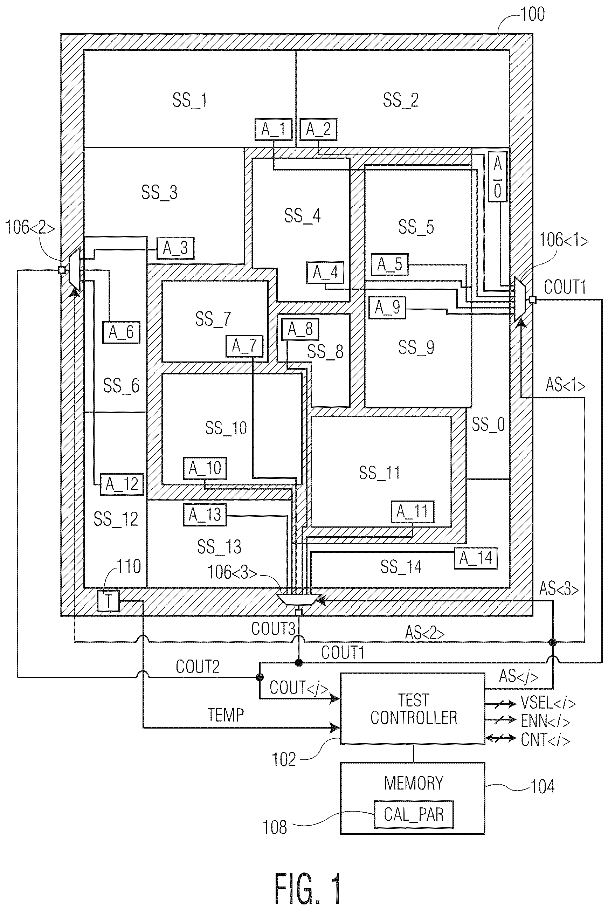

FIG. 1 is a simplified block diagram of a semiconductor chip or integrated circuit (IC) 100 coupled to a test controller 102 which is further coupled to a memory 104, in which the IC 100 incorporates one or more analog circuits each including a rail-to-rail voltage detector implemented according to one embodiment. The IC 100 implements a system-on-chip (SoC) incorporating N+1 subsystems (SS), individually labeled SS_0, SS_1, ..., SS14 (SS_0 - SS_14), each including a corresponding one of multiple analog circuits individually labeled A_0, A_1, ..., A14 (A_0 - A_14). Individual components of the subsystems SS_0 - SS_14 and the analog circuits A_0 - A_14 may be denoted SS_*i* and A_*i*, respectively, in which *"i"* is an index from 0 to N. Although 15 (for N = 14) different subsystems SS_*i* and corresponding analog circuits A-i are shown, it is understood that the IC 100 may incorporate any number of subsystems and analog circuits more or less than 14 depending upon the particular implementation. Each subsystem SS_*i* may perform a different function of the SoC depending upon the particular application. Also, although not specifically shown, each subsystems SS_*i* may be duplicated on the IC 100, meaning each subsystem may include one or more instances of the same subsystem function. Each analog circuit A_*i* serves each of the instances of a corresponding subsystem SS_*i*. For example, assuming the subsystem SS_3 includes five subsystem instances, the analog circuit A_3 serves all five instances of SS_3.

Each analog circuit A_*i* provides a selected output to an input of a corresponding one of multiple output select circuits shown as output multiplexers (MUXes) 106. As shown, three output MUXes 106<1>, 106<2>, and 106<3> are included, although it is understood that any number of MUXes 106 may be included depending upon the configuration. In general, there may be "P" output MUXes 106 provided on the IC 100, generally denoted MUX 106<*j*>, in which "*j*" is an index from 1 to P. As shown, the analog circuits A_0, A_1, A_2, A_4, A_5, and A_9 each provide a selected output to a corresponding input of the MUX 106<1>, the analog circuits A_3, A_6, and A_12 each provide a selected output to a corresponding input of the MUX 106<2>, and the analog circuits A_7, A_8, A_10, A_11, A_13, and A_14 each provide a selected output to a corresponding input of the MUX 106<3>.

The test controller 102 provides corresponding sets of select signals AS<*j*> (e.g., AS<1>, AS<2>, and AS<3> for P = 3) to the corresponding select inputs of the MUXes 106<*j*> for selecting an output of an analog circuit A_*i* providing a selected output to the corresponding MUX. The MUXes 106<*j*> provide corresponding outputs COUT<*j*> (e.g., COUT1, COUT2, and COUT3) to respective inputs of the test controller 102. For example, the test controller 102 provides the AS2 signals for selecting the output of one of the analog circuits A_3, A_6, and A_12 as the output COUT2 provide to the test controller 102.

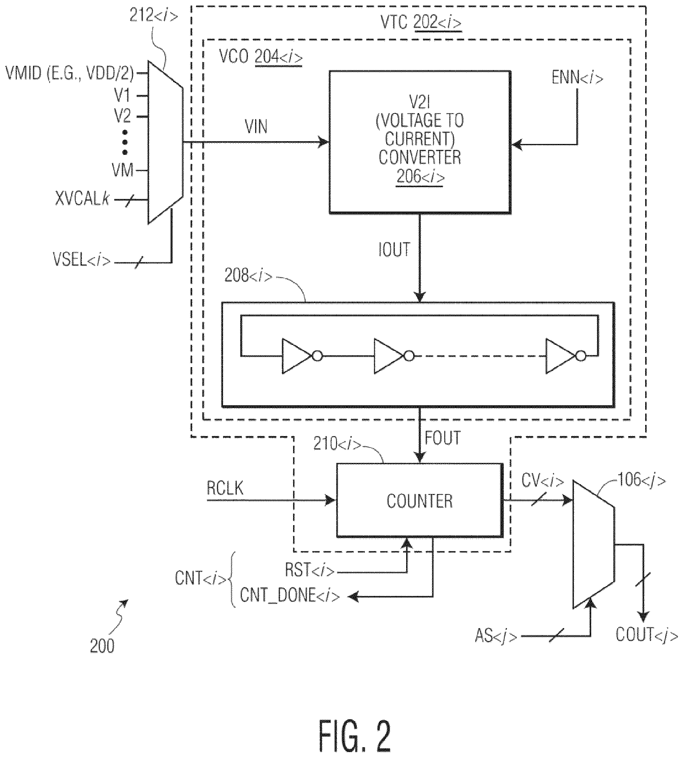

As described further herein, each analog circuit A_*i* includes an internal voltage to time converter (VTC) 202 (e.g., VTC *202<i>* of FIG. 2) for converting a selected input voltage VIN into a corresponding digital count value CV_*i*. Since the input voltage is analog and the output is a digital value, the VTC may alternatively be referred to as an analog to digital converter (ADC). In addition, each analog circuit A_*i* includes an internal input MUX 212 (e.g., MUX 212<*i*> of FIG. 2) for selecting from among multiple analog input voltages of the corresponding analog circuit A_*i* or corresponding subsystem SS_*i* to be detected and measured, and for providing the selected voltage as VIN to the input of a corresponding VTC 202. The test controller 102 provides corresponding sets of select signals VSEL<i> to the select inputs of the MUXes 212 of the analog circuits A_*i*. Also, each VTC 202 includes an internal voltage-controlled oscillator (VCO) 204 (e.g., VCO *204<i>* of FIG. 2) which further includes a voltage to current (V2I) converter 206 (e.g., V2I converter 206<*i*> of FIG. 2) that receives a polarity enable input ENN<i> provided by the test controller 102 for selecting from among multiple internal voltage converters for voltage measurement as further described herein. In one embodiment, the polarity enable input ENN<i> selects either an internal NMOS V2I converter or an internal PMOS V2I converter. In addition, each VCO 204 includes an internal counter 210 (e.g., counter 210<*i*> of FIG. 2) that is controlled and accessed by a corresponding set of counter signals CNT<*i*> provided between the test controller 102 and each of the internal counters 210 as further described herein.

The VCO 204 of each VTC 202 has a gain and offset that varies across process, voltage, and temperature (PVT) corners. Each VTC 204 is therefore calibrated using different input voltages and temperatures to develop calibration parameters that are stored in the memory 104 at a memory location shown as CAL_PAR store 108. The IC 100 may incorporate at least one temperature sensor 110 providing a temperature value TEMP to the test controller 102 indicative of the ambient or overall temperature of the IC 100. Although only one temperature sensor 110 is shown, it is understood that multiple temperature sensors may be distributed across the IC 100, such as including a separate temperature sensor within each of one or more of the subsystems SS_*i*.

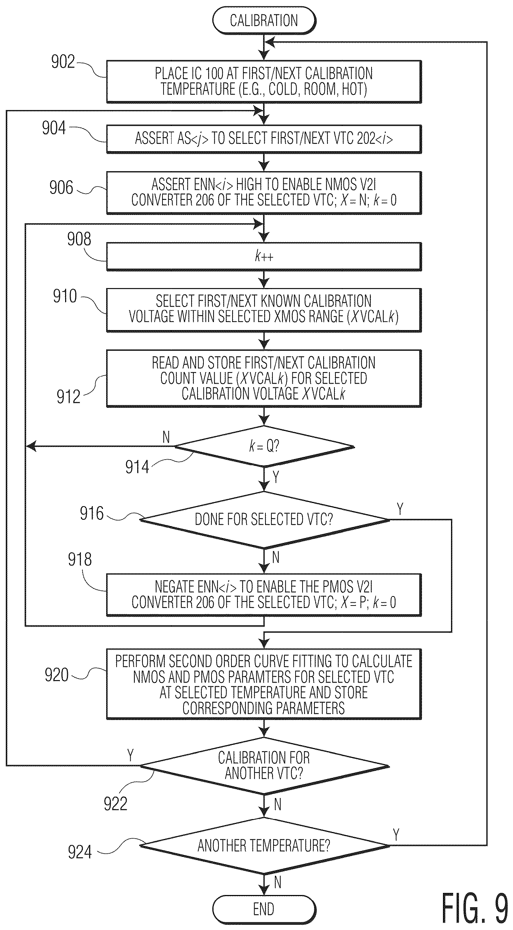

FIG. 2 is a simplified block diagram of a voltage detector 200 implemented according to one embodiment that may be used in any up to all of the analog circuits A_*i*. The voltage detector 200 includes the VTC *202<i>* implemented according to one embodiment coupled to a corresponding input MUX 212<*i*> for selecting an input voltage VIN and a corresponding output MUX 106<*j*> for providing a corresponding measured count value CV<*i*> to the test controller 102. It is understood that the VTC *202<i>,* the input MUX 212<*i*>, and output MUX 106<*j*> represent a substantially similar voltage detector provided within each of the analog circuits A_*i*. Each analog circuit A_*i* includes various analog circuitry and functions developing multiple analog voltages, such as band-gap voltages, input/output (I/O) voltages, pad voltages, sensor voltages, reference voltages, etc. The input MUX 212<*i*> has multiple inputs receiving a reference voltage VMID, "M" input voltages individually referenced as V1, V2, ..., VM, and a set of calibration voltages *X*VCAL*k*. VMID is used as a test voltage for determining which V2I converter to use for voltage measurement as further described herein. In one embodiment, VMID = VDD/2 although VMID may be adjusted based on the relative voltage ranges of the V2I converters. The M input voltages represent the one or more analog voltages of the analog circuit A_*i* and the corresponding subsystem SS_*i* that need to be sampled and measured for purposes of validation during testing. The set of values XVCALk denotes multiple calibration voltages that may be determined for a given configuration, in which *"X"* denotes a selected polarity between N and P and *"k"* is an index from 1 to Q, in which Q denotes the total number of calibration voltages for each polarity as further described herein (e.g., see FIG. 9).

As previously described, the test controller 102 asserts VSEL<*i*> for selecting from among the input voltages of the input MUX 212<*i*> to provide a selected input voltage VIN to the VTC *202<i>.* As previously described, each VTC *202<i>* includes a corresponding VCO *204<i>* which receives and converts the selected input voltage VIN to a corresponding frequency signal FOUT. Each VCO *204<i>* includes a V2I converter 206<*i*> receiving VIN and a corresponding polarity enable input ENN<*i*> from the test controller 102 and configured to convert VIN to an output current IOUT. IOUT is provided to an input of a corresponding oscillator 208<*i*> within the VCO *204<i>* configured to convert IOUT into the corresponding frequency signal FOUT. The oscillator 208<*i*> may be implemented in any suitable manner, such as, for example, a delay pipeline including an odd number of inverters coupled in series with a feedback loop in which IOUT is provided as a source input to each of the inverters. Thus, as VIN increases (or decreases), IOUT increases (or decreases) and FOUT correspondingly increases (or decreases). In this manner, the VCO *204<i>* converts VIN to a corresponding frequency signal FOUT.

FOUT is provided to an input of a corresponding counter 210<*i*>, which is configured to convert FOUT to a corresponding digital output count value CV<*i*>. In one embodiment, each set of CNT<*i*> signals between the test controller 102 and the counter 210<*i*> includes a reset signal RST<*i*> and a count done signal CNT_DONE<*i*>. The counter 210<*i*> also receives a reference clock signal RCLK that may be generated on the IC 100 or provided externally. In one embodiment, RCLK is programmed to have a frequency that is substantially less than the expected frequency range of FOUT. As an example, assume FOUT may have a frequency that ranges around 1 gigahertz (GHz) whereas RCLK is programmed with a frequency of 40 megahertz (MHz). In one embodiment, the counter 210<*i*> is programmed with an RCLK count value or the like for counting a predetermined number of cycles of FOUT. In operation, when the reset signal RST<*i*> is negated, CV<*i*> starts at zero (or some other initial value) and increments with each FOUT cycle for the total number of RCLK cycles defined by the RCLK count value. When the number of RCLK cycles defined by the RCLK count value is reached, the CV<*i*> is held constant and the count done signal CNT_DONE<*i*> is asserted. As an example, if RCLK is 40MHz, the RCLK count value is 100, and FOUT is 1GHz, then CV<*i*> is in the range of about 2,500. It is understood that this described operation is only one of many different methods of counting FOUT clock cycles using a counter.

It is noted that the oscillator 208<*i*> and the counter 210<*i*> may collectively form a current to digital converter providing a corresponding output value CV<*i*> as a measured value. The resulting output value CV<*i*> is provided to one input of the corresponding output MUX 106<*j*>. The test controller 102 asserts the corresponding select signals AS<*j*> of the output MUX 106<*j*> in order to access and read the count value CV<*i*> as COUT<*j*>.

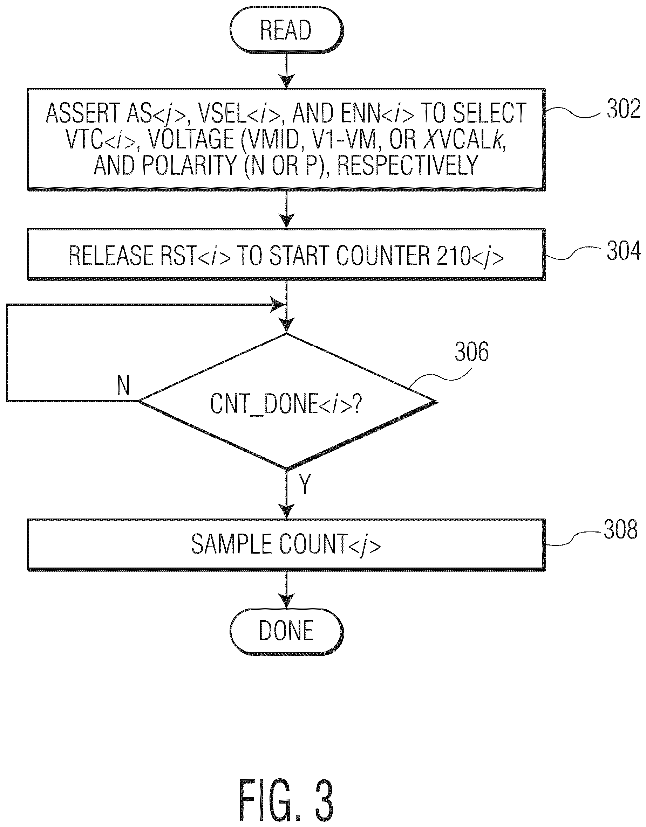

FIG. 3 is a flowchart diagram illustrating operation of the test controller 102 performing a read operation of a selected voltage on the IC 100 according to one embodiment. At a first block 302, the test controller 102 asserts AS<*j*>, VSEL<*i*>, and ENN<*i*> to select a VTC 202<*i*>*,* an input voltage VIN (e.g., VMID, V1 - VM, or XVCAL*k*), and a corresponding V2I polarity (N for a corresponding NMOS V2I converter or P for a corresponding PMOS V2I converter) of the selected VTC 202, respectively. At next block 304, the test controller 102 releases (or negates) RST<*i*> to start the corresponding counter 210<*i*> for counting cycles of FOUT. At next block 306, the test controller 102 monitors the CNT_DONE<*i*> signal for determining when the count operation is completed. While CNT_DONE<*i*> is false, operation loops at block 306. When CNT_DONE<*i*> is true, operation advances to block 308 in which the test controller 102 samples CV<*i*> as COUT <*j*>.

Each of the VTC's 202, as represented by the VTC 202<*i*>*,* is configured as a time-based analog to digital converter (ADC) that is very suitable for their compact area and sufficient resolution. Such time-based ADC's, however, have a limited input voltage range because of non-linearity in the extended voltage range between the lower rail and the upper rail and thus have not been suitable for rail-to-rail operation. The existing nonlinearity mitigation schemes for a rail-to-rail input negatively impacts IC area by adding analog components such as constant transconductance stages or analog comparators or the like. It is desired, however, not to substantially impact the amount of IC area consumed. The VTC's 202, as represented by the VTC 202<*i*>*,* are configured with a corresponding V2I converter 206, as represented by the V2I converter 206<*i*>, to achieve rail-to-rail operation without substantially impacting area consumption as further described herein.

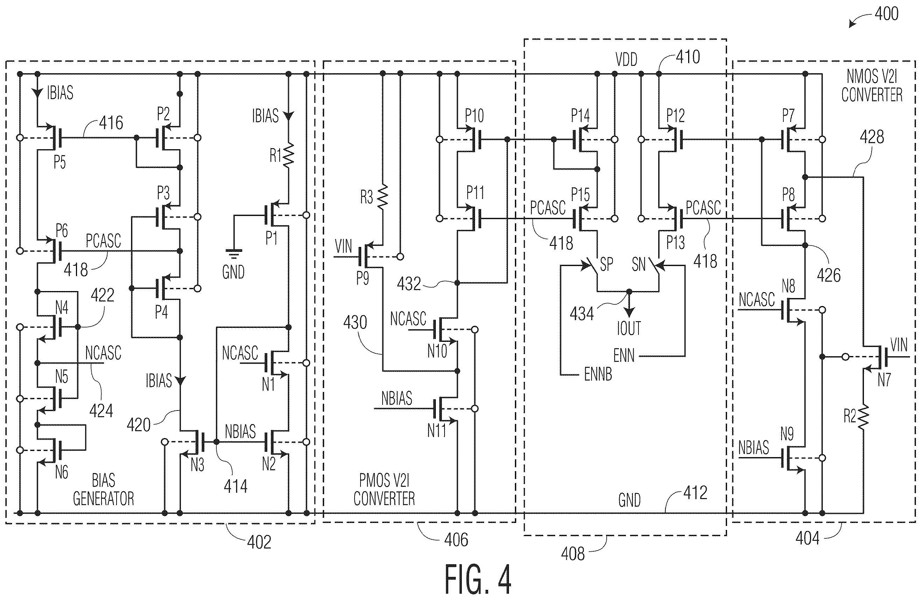

FIG. 4 is a schematic diagram of a V2I converter 400 implemented according to one embodiment which may be used as any of the V2I converters 206 (e.g., the V2I converter 206<*i*> shown in FIG. 2) of any of the VCO's 204 of the corresponding VTC's 202. The V2I converter 400 includes a bias generator 402, an NMOS V2I converter 404, a PMOS V2I converter 406, and an output stage 408. The V2I converter 400 is coupled between an upper supply voltage VDD developed on a node 410 and a lower supply voltage developed on a node 412, and includes NMOS transistors N1 - N11, PMOS transistors P1 - P15, resistors R1 - R3, and switches SP and SN. VDD may have any suitable voltage level, such as 1.6 Volts (V), and the lower supply voltage on node 412 may have any suitable supply reference voltage level, such as 0V or ground (GND). Each of the PMOS transistors has a body or bulk connection coupled to VDD and each of the NMOS transistors has a body or bulk connection coupled to GND.

The bias generator 402 includes P1 - P6, N1 - N6, and the resistor R1. R1 is coupled between VDD and a source terminal of P1, which has a gate terminal coupled to GND and a drain terminal coupled a node 414 developing an N-type bias voltage NBIAS. N1 has a drain terminal coupled to node 414, a gate terminal receiving an N-type cascade voltage NCASC, and a source terminal coupled to the drain terminal of N2. N2 and N3 have gate terminals coupled together at node 414 and source terminals coupled to GND. P2 has a source terminal coupled to VDD and gate and drain terminals coupled together at a node 416, which is further coupled to a gate terminal of P5 and to a source terminal of P3. P3 and P4 have gate terminals coupled together at a node 420, which is further coupled to a drain terminal of N3 having a source terminal coupled to GND. P3 has a drain terminal coupled to a source terminal of P4 at a node 418 developing a P-type cascade voltage PCASC. P5 has a source terminal coupled to VDD and a drain terminal coupled to a source terminal of P6. P6 has a gate terminal coupled to node 418 and a drain terminal coupled to a node 422, which is further coupled to a drain terminal of N4 and to the gate terminals of N4 and N5. N4 has a source terminal coupled to a drain terminal of N5 at a node 424 developing the NCASC voltage. N5 has a source terminal coupled to a drain terminal and a gate terminal of N6, which has a source terminal coupled to GND.

The NMOS V2I converter 404 includes P7 - P8, N7 - N9, and the resistor R2. P7 has a source terminal coupled to VDD, a gate terminal coupled to a node 426, and a drain terminal coupled to a node 428 which is further coupled to a source terminal of P8 and a drain terminal of N7. N7 has a gate terminal receiving VIN and a source terminal coupled to one end of R2, which has its other end coupled to GND. P8 has a gate terminal coupled to node 418 for receiving PCASC and a drain terminal coupled to node 426. N8 has a drain terminal coupled to node 426, a gate terminal coupled to node 424 for receiving NCASC, and a source terminal coupled a drain terminal of N9. N9 has a gate terminal coupled to node 414 for receiving NBIAS and a source terminal coupled to GND.

The PMOS V2I converter 406 includes P9 - P11, N10 - N11, and the resistor R3. R3 is coupled between VDD and a source terminal of P9, which has a gate terminal receiving VIN and a drain terminal coupled to a node 430. P10 has a source terminal coupled to VDD, a gate terminal coupled to a node 432, and a drain terminal coupled to a source terminal of P11. P11 has a gate terminal coupled to node 418 for receiving PCASC and a drain terminal coupled to node 432. N10 has a drain terminal coupled to node 432, a gate terminal coupled to node 424 for receiving NCASC, and a source terminal coupled to node 430. N11 has a drain terminal coupled to node 430, a gate terminal coupled to node 414 for receiving NBIAS, and a source terminal coupled to GND.

The output stage 408 includes P12 - P15 and the switches SN and SP. P12 and P14 have source terminals coupled to VDD. P12 has a gate terminal coupled to node 426 and a drain terminal coupled to the source terminal of P13. P14 has a gate terminal coupled to node 432 and a drain terminal coupled to the source terminal of P15. P13 has a drain terminal coupled to one end of the switch SN and P15 has a drain terminal coupled to one end of the switch SP. The other ends of the switches SN and SP are coupled together at an output node 434 providing IOUT. An enable signal ENN is shown provided to a control input of the switch SN and an inverted enable signal ENNB (in which a "B" appended at the end of a signal name denotes logical negation unless otherwise specified) is provided to a control input of the switch SP. ENN represents a corresponding one of the ENN<*i*> enable signals provided by the test controller 102, and ENNB is an inverted version of the corresponding ENN<*i*> enable signal. When ENN is asserted high so that ENNB is asserted low, switch SN is closed to enable the NMOS V2I converter 404 and switch SP is opened to disable the PMOS V2I converter 406. Similarly, when ENN is asserted low so that ENNB is asserted high, switch SN is opened to disable the NMOS V2I converter 404 and switch SP is closed to enable the PMOS V2I converter 406.

It is noted that the ENN<*i*> signal previously described controls or otherwise represents both ENN and ENNB. For example, an inverter (not shown) may be included having an input receiving ENN and an output providing ENNB. Alternatively, the switch SN may be configured as normally-open while the switch SP is configured as normally-closed, or vice-versa, so that both may be controlled by the same enable signal ENN.

In operation of the bias generator 402, R1 and P1 are configured to generate a bias current IBIAS which flows through the cascade configuration of N1 and N2 to develop the NBIAS voltage on node 414. N2 and N3 are configured in a current-mirror configuration so that IBIAS (or a proportional version thereof) flows through the cascaded configuration of P2 - P4 which are configured to develop the PCASC voltage on node 418. P2 and P5 are configured in a current-mirror configuration so that IBIAS (or a proportional version thereof) flows through the cascaded configuration of N4 - N6 for developing the NCASC voltage on node 424. The NBIAS, PCASC, and NCASC voltages are used as bias voltages for the NMOS and PMOS V2I converters 404 and 406 and the output stage 408.

In operation of the NMOS V2I converter 404 when enabled in conjunction with the output stage 408 when switch SN is closed by ENN, a fixed current flows through the cascaded configuration of N8 - N9 and a variable current flows through N7 based on the voltage level of VIN. The combination of the fixed current and the variable current is mirrored through P12 and P13 to develop IOUT. When VIN has a sufficiently low voltage level to turn off N7, then IOUT is substantially equal to the fixed current effectively establishing an N-type quiescent current level of IOUT. As VIN is increased turning on N7, the variable current through N7 is increased so that the current of IOUT is increased accordingly. Within a certain upper voltage range up to VDD, IOUT is increased substantially linearly with VIN. It is noted, however, that as VIN is decreased, IOUT reaches the N-type quiescent current level before VIN reaches GND so that the NMOS V2I converter 404 is ineffective in the lower voltage range of VIN between the N-type quiescent current level and GND.

In operation of the PMOS V2I converter 604 when enabled in conjunction with the output stage 408 when switch SP is closed by ENNB, when VIN has a sufficiently high voltage level to turn off P9, then a P-type quiescent current level flows through the cascaded configuration of P10 - P11 and N10 - N11 which is mirrored through P14 - P15 as IOUT. When VIN is decreased well below VDD to a saturation point, P9 begins turning on and provides a part of the quiescent current. As VIN is decreased below the saturation point, IOUT is decreased by a substantially linear amount all the way down to GND. Within a certain lower voltage range down to GND, IOUT is decreased substantially linearly with VIN. It is noted, however, that as VIN is increased, IOUT reaches the P-type quiescent current level well before VIN reaches VDD so that the PMOS V2I converter 406 is ineffective in the upper voltage range of VIN between the P-type quiescent current level and VDD.

As described further herein, the N-type quiescent current level is less than the P-type quiescent current level. In addition, the linear operating range of the NMOS V2I converter 404 begins at a first voltage above the N-type quiescent current level all the way up to VDD, and the linear operating range of the PMOS V2I converter 406 begins at GND all the way up to a second voltage less than the P-type quiescent current level but still greater than the first voltage of the NMOS V2I converter 404. In this manner, there is an overlapping linear region between the PMOS V2I converter 406 and the NMOS V2I converter 404 so that linear operation may be achieved rail-to-rail, that is from GND to VDD. Operation is substantially linear meaning not exactly linear and operation does vary across PVT changes. As described further herein, calibration is performed to minimize dependence upon temperature and gain with PVT variations.

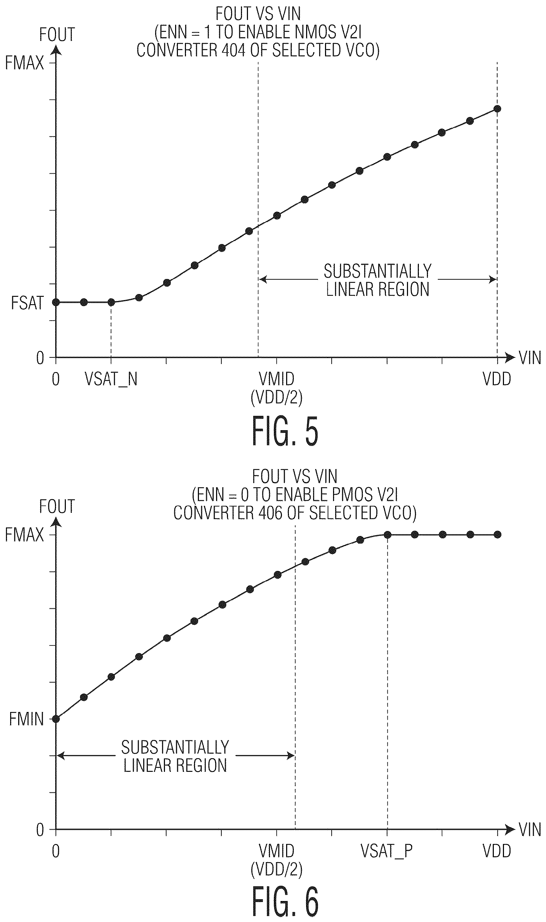

FIG. 5 is a plot of FOUT versus VIN of selected VIN values ranging from GND to VDD (rail-to-rail) of a selected VCO 204 using the V2I converter 400 in which ENN = 1 to enable the NMOS V2I converter 404 while applying IOUT to a corresponding oscillator 208 according to one embodiment. The V2I converter 400 and the oscillator 208 are configured so that FOUT ranges from a saturation frequency FSAT to a maximum frequency FMAX for VIN ranging from GND (0V) to VDD. In one embodiment, VDD is about 1.6V and FMAX is about 1.6GHz, although alternative VIN voltage ranges and corresponding frequency ranges are contemplated. When VIN is at or below an N-type saturation voltage VSAT_N which is greater than 0V, FOUT remains fixed at the saturation frequency FSAT. As VIN varies between VSAT_N and a middle voltage value VMID (e.g., VDD/2), FOUT varies in a substantially non-linear manner. While VIN is between a voltage just below VMID and VDD shown as a substantially linear region, FOUT varies with VIN in a substantially linear manner.

FIG. 6 is a plot of FOUT versus VIN of selected VIN values ranging from GND to VDD (rail-to-rail) of a selected VCO using the V2I converter 400 in which ENN = 0 to enable the PMOS V2I converter 406 while applying IOUT to a corresponding oscillator 208 according to one embodiment. The V2I converter 400 and the oscillator 208 are configured so that FOUT ranges from a minimum frequency FMIN to a maximum frequency FMAX for VIN ranging from GND (0V) to VDD. In one embodiment, VDD is about 1.6V and FMAX is about 1.6GHz, although alternative VIN voltage ranges and corresponding frequency ranges are contemplated. When VIN is at or above a P-type saturation voltage VSAT_P which is greater than VMID, FOUT remains fixed, such as at FMAX. As VIN varies between VSAT_P and just above VMIN (e.g., VDD/2), FOUT varies in a substantially non-linear manner. While VIN is between 0V and a voltage just above VMID shown as a substantially linear region, FOUT varies with VIN in a substantially linear manner.

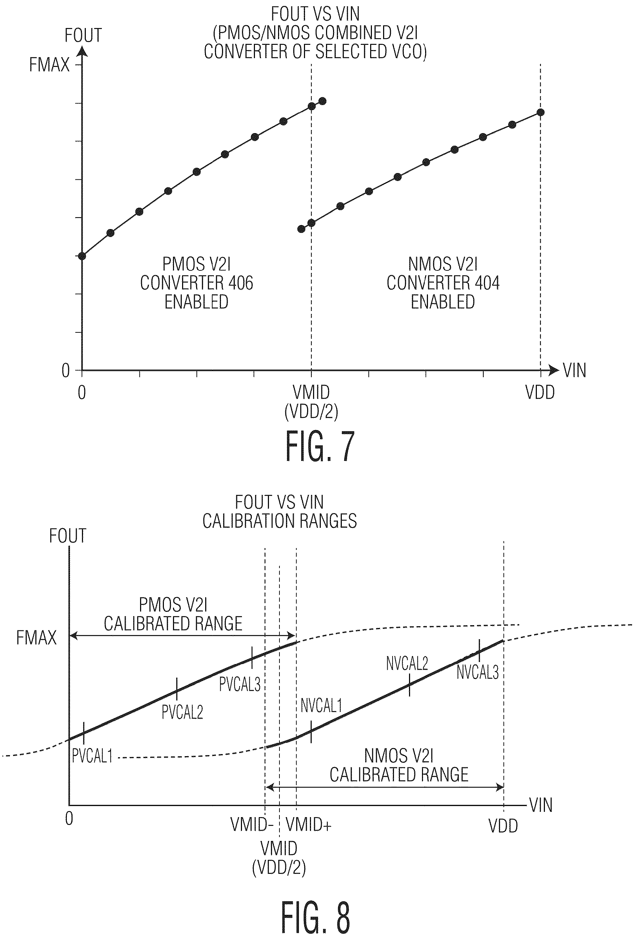

FIG. 7 is a plot of FOUT versus VIN of selected VIN values ranging from GND (0V) to VDD (rail-to-rail) of a selected VCO while enabling the PMOS V2I converter 406 of the V2I converter 400 in a first voltage range and while enabling the NMOS V2I converter 404 in a second voltage range. In each case, IOUT is applied to a corresponding oscillator 208 for generating FOUT. The polarity enable input ENN = 0 to enable the PMOS V2I converter 406 for VIN between 0V and a voltage just above VMID, shown as VMID+, and the polarity enable input ENN = 1 to enable the NMOS V2I converter 404 for VIN between VDD and a voltage just below VMID, shown as VMID-. Operation is substantially linear when the PMOS V2I converter 406 is enabled from 0V to VMID+, and operation is substantially linear when the NMOS V2I converter 404 is enabled from VMID- to VDD. FIG. 7 illustrates rail-to-rail substantially linear operation so long as the appropriate NMOS or PMOS V2I converter is enabled when VIN is within the corresponding linear operating range.

FIG. 8 is a plot of PMOS and NMOS calibration ranges of FOUT versus VIN ranging from GND to VDD (rail-to-rail) of a selected VCO while applying IOUT to a corresponding oscillator 208. The PMOS and NMOS calibration ranges, shown bolded, correlate with the substantially linear regions shown in Figures 5 and 6 as shown combined in Figure 7. The phrase "substantially linear" means that operation is not exactly linear and thus may be partially non-linear. In this manner, the selected VCO is calibrated in the VIN voltage range from 0V to VMID+ while the PMOS V2I converter 406 is enabled, and the selected VCO is calibrated in the voltage range from VMID- to VDD while the NMOS V2I converter 404 is enabled.

A calibration procedure may be performed for each VTC *202<i>* while enabling each of the NMOS and PMOS V2I converters within the calibration regions as further described herein. In one embodiment, the test controller 102 selects multiple known calibration voltages *X*VCAL*k* within the PMOS and NMOS calibration ranges while performing the respective calibration procedure. As shown, for example, three calibration voltages PVCAL1, PVCAL2, and PVCAL3 (e.g., *X* = P and Q = 3, so that k = 1, 2, 3) may be selected within the PMOS calibration range, and another three calibration voltages NVCAL1, NVCAL2, and NVCAL3 (e.g., *X* = N and Q = 3, so that k = 1, 2, 3) may be selected within the NMOS calibration range and a curve-fitting method, such as a second order curve fitting or the like, is used to calculate the output (FOUT or digital count output) for any given input voltage within the calibrated voltage range. It is noted that the set of calibration voltages XVCALk may be generated on-chip on the IC 100, or provided externally, such as by the test controller 102.

FIG. 9 is a flowchart diagram illustrating a calibration procedure for calibrating each of the VTCs 202 of the IC 100 according to one embodiment. At a first block 902, the IC 100 is placed at a first or next temperature value of a set of temperature values used for calibration. In one embodiment, the temperature sensor 110 is used to enable the test controller 102 to identify the temperature value during calibration. Alternatively, a corresponding one of multiple temperature sensors distributed across the IC 100 may be used instead. In one embodiment, three temperature values are selected for calibration, including a COLD temperature such as -40 degrees Celsius (°C), a ROOM temperature such as 20°C, and a HOT temperature such as 125°C. Alternative temperature values may be used and additional temperature values may be included for calibration in different embodiments. Block 902 is repeated in successive iterations to perform calibration using each of the different temperature values.

At next block 904, the test controller 102 asserts AS<*j*> to select the first or next VTC *202<i>* in successive iterations. For example, the test controller 102 may assert the AS<1> signals to cause the MUX 106<1> to select the VTC 202<0> of the analog circuit A_0 in the first iteration, may assert the AS<1> signals to cause the MUX 106<1> to select the VTC 202<1> of the analog circuit A_1 in the second iteration, and so on. At next block 906, the test controller 102 may assert the ENN<*i*> signal high to enable the NMOS V2I converter 206 of the selected VTC. The variable *X* used to denote a selected polarity between N and P is initially set to *X =* N to select NMOS, and the index value *k,* which is used to increment between successive calibration voltages *X*VCAL*k*, is set to an initial value of zero. At a next block 908, the index value *k* is incremented (from 0 to 1 in the first iteration). At next block 910, the first or next known calibration voltage *X*VCAL*k* is selected within the selected *X*MOS range. In the first iteration in which *X* = N and *k =* 1, for example, the test controller asserts VSEL*i* to select the corresponding calibration voltage NVCAL1.

At next block 912, the test controller 102 performs the read procedure described in FIG. 3 to read a first or next calibration count value *X*CCAL*k* for the selected calibration voltage *X*VCAL*k* and to store the calibration count value in the memory 104. As previously described with reference to FIG. 3, the test controller 102 at this point has selected a VTC 202, the calibration voltage, and the polarity of step 302, and is ready to read the corresponding count value CV<*i*> as COUT<*j*>. Although calibration in FIG. 8 was described in terms of frequency or FOUT, the corresponding FOUT is applied to the corresponding counter 210<*i*> to determine CV<*i*>. Thus, the test controller 102 performs block 304 by releasing the corresponding reset signal RST<*i*> to start the counter 210<*i*>, waits for the corresponding count done value CNT_DONE<*i*> to be asserted, and then samples COUT<*j*> as the calibration count value *X*CCAL*k* for the selected calibration voltage *X*VCAL*k*. In the first iteration for a given VTC 202 for the calibration voltage NVCAL1, the corresponding calibration count value is NCCAL1.

After reading and storing the calibration count value *X*CCAL*k* at block 912, operation advances to block 914 to inquire whether the index value *k* = Q, in which Q indicates the last calibration voltage for a given VTC 202 and polarity. If *k* has not yet advanced to Q, then operation loops back to block 908 in which the index value *k* is incremented for determining the next calibration count value for the next calibration voltage. For example, after determining NCCAL1 for NVCAL1, operation loops back to block 908 in which *k* is incremented to 2, the next calibration voltage NVCAL2 is selected at block 910, and the corresponding calibration count value NCCAL2 is read and stored at block 912. Operation loops between blocks 908 - 914 for determining each calibration count value *X*CCAL*k* for the corresponding calibration voltages *X*VCAL*k* for the selected VTC and selected polarity until *k* = Q. For example, for Q = 3 for *X =* N for a selected VTC, the test controller 102 reads and stores calibration count values NCCAL1, NCCAL2, and NCCAL3, for corresponding calibration voltages NVCAL1, NVCAL2, and NVCAL3, respectively.

When k = Q as determined at block 914, operation advances to block 916 to inquire whether calibration operation is completed for the selected VTC 202. After calibration for polarity *X =* N is completed, calibration for polarity *X =* P is performed to the selected VTC 202. Thus operation advances to block 918 in which ENN<i> is negated to enable the corresponding PMOS V2I converter 406 of the selected VTC 202, *X* is set equal to P (or *X =* P for PMOS), and the index value k is reset back to 0. Operation then loops back to block 908 in which blocks 908 - 912 are repeated for PMOS calibration until k = Q. For example, for Q = 3 for *X =* P for a selected VTC, the test controller 102 reads and stores calibration count values PCCAL1, PCCAL2, and PCCAL3, for corresponding calibration voltages PVCAL1, PVCAL2, and PVCAL3, respectively, in a similar manner described above for NMOS calibration.

After calibration is completed for a selected VTC 202 as determined at block 916 (meaning that both NMOS and PMOS calibrations have been performed), operation advances instead to block 920 in which second order curve fitting is performed to calculate the NMOS and PMOS parameters for the selected VTC at the selected temperature and the calculated parameters are stored in the memory 104, such as at CAL_PAR store 108.

Operation then advances to block 922 to inquire whether calibration is to be performed for another VTC. If so, operation loops back to block 904 in which the test controller asserts AS<*j*> to select the next VTC *202<i>,* then to block 906 to set ENN<*i*> high to enable the corresponding NMOS V2I converter 406 of the next selected VTC 202, to set *X* = N, and to reset index *k* back to 0. Operation then loops between blocks 908 to 918 to determine the NMOS and PMOS calibration count values for the next VTC, 202 and then the test controller 102 performs the second order curve fitting at block 920 to calculate the NMOS and PMOS parameters for the next VTC at the currently selected temperature and the calculated parameters are stored in the memory 104, such as at CAL_PAR store 108. Operation loops at block 922 to determine and store the NMOS and PMOS calibration parameters for each VTC *202<i>* of each of the analog circuits A_*i* of the IC 100.

After the NMOS and PMOS calibration parameters for each VTC *202<i>* of each of the analog circuits A_*i* of the IC 100 have been determined and stored at the selected temperature, operation advances to block 924 to inquire whether calibration is completed at each of the calibration temperatures. If not, operation loops back to block 902 to place the IC 100 at the next calibration temperature, and then operation advances to block 904 to once again select the first VTC 202 at the newly selected temperature. Operation loops between blocks 902 and 924 until the NMOS and PMOS calibration parameters have been determined for each VTC at each calibration temperature, and then calibration operation is completed.

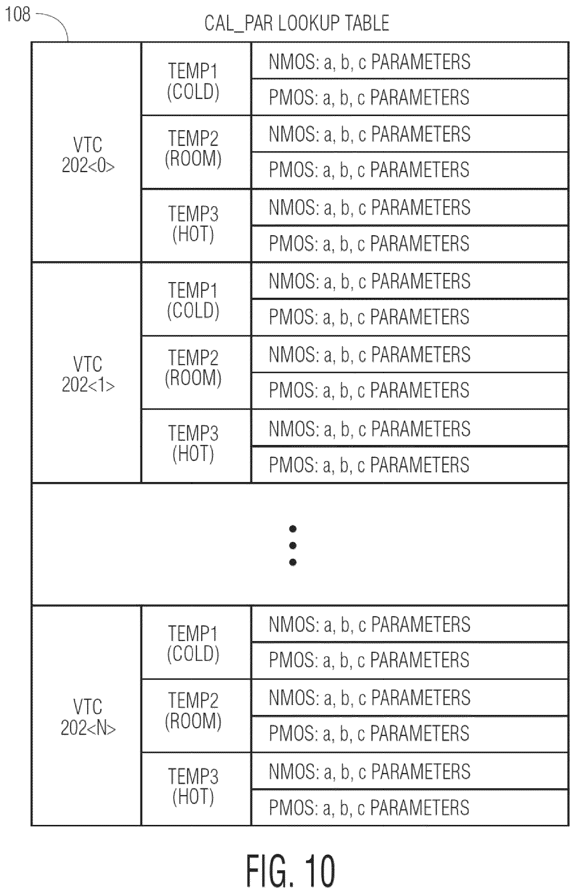

FIG. 10 is a block diagram illustrating the CAL_PAR store 108 configured as a lookup table (LUT) implemented according to one embodiment for storing the calibration parameters. The CAL_PAR LUT stores NMOS and PMOS parameters a, b, and c used for second order curve fitting for each calibration temperature (e.g., TEMP1 = COLD, TEMP2 = ROOM, TEMP3 = HOT) for each VTC *202<i>* of the IC 100 (e.g., VCT 202<0>, VTC 202<1>, ..., VTC 202<N>). It is noted that more or less than 3 temperature values may be included and that more or less calibration voltages may be used depending upon the calibration method.

In a simplified variation according to another embodiment, block 904 of FIG. 9 is revised in which the test controller 102 asserts AS<*j*> to select an exemplary VTC *202<i>* of the IC 100 and block 920 is eliminated. Thus, the NMOS and PMOS parameters are measured for each of the temperature values for only one exemplary VTC which is then used for each of the VTC's during operation. The LUT of FIG. 10 is reduced accordingly for providing NMOS and PMOS parameters for only one VTC which may be used for all of the VTC's during operation.

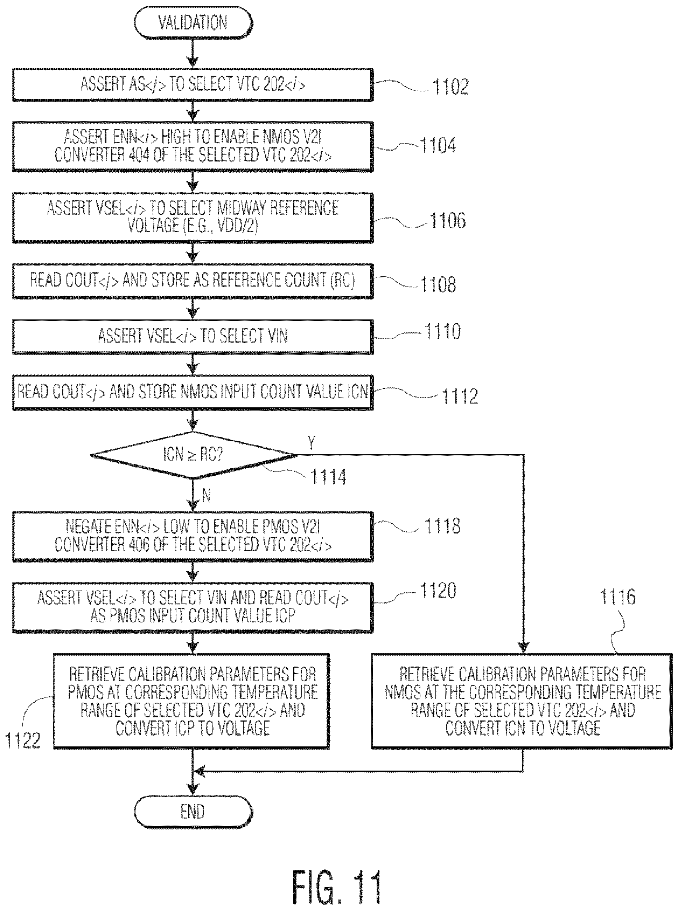

FIG. 11 is a flowchart diagram illustrating operation of the test controller 102 controlling the voltage detector 200 incorporating the V2I converter 400 for measuring and validating a selected input voltage VIN according to one embodiment. At a first block 1102, the test controller 102 asserts a set of select signal AS<*j*> provided to a corresponding one of the MUXes 106<*j*> to select a corresponding VTC *202<i>.* At next block 1104, the test controller 102 asserts ENN<*i*> high to enable the corresponding NMOS V2I converter 404 of the selected VTC 202*<i>.* At next block 1106, the test controller 102 asserts VSEL<*i*> to select the corresponding midway reference voltage VMID. It is noted that VMID may be VDD/2, but may be another midway voltage in the overlapping calibration regions shown in FIG. 8. The test controller 102 then performs the read procedure previously described in FIG. 3 to read the corresponding count value CV<*i*> as COUT<*j*> and to store in the memory 104 the count value as a reference count value RC at block 1108.

At next block 1110, the test controller 102, still selecting the same VTC *202<i>,* asserts VSEL<*i*> to select the VIN voltage to be validated. The test controller 102 then performs the read procedure again to read the corresponding count value CV<*i*> as COUT<*j*> and to store in the memory 104 the count value as an NMOS input count value ICN at block 1112. At next block 1114, it is determined whether ICN ≥ RC. If so, then it is known that VIN is within the NMOS linear and calibrated region so that operation advances to block 1116.

At block 1116, the test controller 102 retrieves the calibration parameters for NMOS at the corresponding temperature value or range of the selected VTC 202*<i>* from the CAL_PAR store 108, and the count value ICN corresponding with VIN is converted to voltage, and operation is completed. Of course, additional validation steps (not shown) may be taken after detection and conversion, such as comparing the converted voltage to other voltage values or to an expected voltage range of VIN. Also, to make the determination, the test controller 102 reads TEMP from the temperature sensor 110 (or any other suitable temperature sensor on the IC 100) and compares TEMP with the calibration temperatures TEMP1, TEMP2, and TEMP3 for determining which of the calibration parameters to retrieve from the CAL_PAR store 108 of the selected VTC *202<i>.* In one embodiment, the test controller 102 simply determines which of the calibration temperatures (TEMP1, TEMP2, TEMP3) is closest to TEMP and uses the corresponding calibration parameters from the CAL_PAR store 108.

Referring back to block 1114, if instead ICN < RC, then it is known that VIN is within the PMOS linear and calibrated region so that operation instead advances to block 1118. At block 1118, the test controller 102 negates ENN<*i*> low to enable the corresponding PMOS V2I converter 406 of the selected VTC *202<i>.* Then at next block 1120 the test controller 102 asserts VSEL<*i*> to select VIN and performs the read procedure (e.g., shown in FIG. 3) to read the corresponding count value CV<*i*> as COUT<*j*> interpreted as a PMOS input count value ICP. At block 1122, the test controller 102 retrieves the calibration parameters for PMOS at the corresponding temperature value or range of the selected VTC *202<i>* from the CAL_PAR store 108 and the count value ICP corresponding with VIN is converted to voltage, and operation is completed. Again, additional validation steps may be taken after detection and conversion.

The flowchart of FIG. 11 may be modified to first enable the PMOS V2I converter 406 at block 1104 by negating ENN<*i*> low. In this case block 1112 is modified to read COUT<*j*> and store as the PMOS input count value ICP, and block 1114 is modified to determine whether ICP ≤ RC. Blocks 1116 and 1122 are swapped, so that if ICP ≤ RC as determined at modified block 1114, the calibration parameters for PMOS are retrieved at the corresponding temperature range and ICP is converted to voltage. If, however, ICP > RC as determined at modified block 1114, then block 1118 is modified to assert ENN<*i*> high to enable the NMOS V2I converter 404, and VIN is selected at block 1120 to read COUT<*j*> as the NMOS input count value ICN. Then operation proceeds to block 1116 (rather than block 1122) to retrieve the calibration parameters for NMOS and convert ICN to voltage. In either case (FIG. 11 as is or as modified), the test controller 102 enables one of the V2I converters (NMOS or PMOS) and sets the selected voltage to a reference voltage indicative of the intermediate voltage for taking a reference measurement, then sets the selected voltage to an input voltage for taking an input measurement using the enabled voltage to current converter, and compares the reference measurement with the input measurement for determining which of the first and second voltage to current converters provides a more accurate measurement. If the enabled V2I current is correct, then the input measurement is converted to voltage. If the enabled V2I is not correct, then the test controller 102 enables the other V2I, sets the selected voltage to the input voltage for taking another input measurement, and converts the input measurement to voltage.

It is noted that the calibration temperatures may spread rather widely and that significant variations may exist in the calibration parameters and the corresponding converted voltages. In another embodiment, the test controller 102 determines the relative value of TEMP with respect to the calibration voltages TEMP1, TEMP2, and TEMP3, selects two of the calibration temperatures between which TEMP is located, and retrieves and performs two separate voltage conversions using the selected calibration temperatures, and calculates VIN as a weighted average of converted values. For example, if TEMP falls midway between TEMP2 and TEMP3, then the corresponding VIN values determined at TEMP2 and TEMP3 may be weighted at about 50% to determine an averaged value. The weighting may be adjusted based on which calibration value is closest. For example, as TEMP is increased towards TEMP3 relative to TEMP2, then TEMP3 may be given a greater weight relative to TEMP2 for making a more accurate determination of VIN.

A voltage detector for measuring a voltage between voltage rails including first and second voltage to current (V2I) converters, a current converter, and a controller. The controller enables the first V2I converter when a selected voltage is between the first voltage rail and an intermediate voltage and enables the second V2I converter when the selected voltage is between the intermediate voltage and the second voltage rail. Each V2I converter converts the selected voltage into an output current when enabled. The current converter converts the output current into a measured value and the controller converts the measured value into an output voltage. The controller may enable either V2I converter and select a reference voltage for determining a reference value, then select an input voltage for determining an input value using the enabled V2I converter, and then compare the reference and input values for determining which V2I converter provides a correct result.

Aspects of the disclosure are defined in the accompanying claims. In a first aspect, there is provided a voltage detector for measuring a voltage between a first voltage rail and a second voltage rail, comprising: a first voltage to current converter configured to convert a selected voltage to an output current when enabled; a second voltage to current converter configured to convert the selected voltage to the output current when enabled; a converter that converts the output current into a corresponding measured value; and a controller configured to enable the first voltage to current converter when the selected voltage is between the first voltage rail and an intermediate voltage that is between the first and second voltage rails, to enable the second voltage to current converter when the selected voltage is between the intermediate voltage and the second voltage rail, and to convert the measured value into an output voltage.

In some embodiments, the controller is configured to enable the first voltage to current converter and to set the selected voltage to a reference voltage indicative of the intermediate voltage for determining a reference value, to set the selected voltage to an input voltage for determining a first input value using the first voltage to current converter, and to compare the reference value with the first input value for determining which one of the first and second voltage to current converters provides a more accurate measurement.

In some embodiments, the first voltage to current converter is determined to provide a more accurate measurement, the controller is configured to convert the first input value into the output voltage; and wherein when the second voltage to current converter is determined to provide a more accurate measurement, the controller is configured to enable the second voltage to current converter, to set the selected voltage to the input voltage for determining a second input value using the second voltage to current converter, and to convert the second input value into the output voltage.

In some embodiments, the second voltage rail is greater than the first voltage rail, and wherein the controller is configured to enable the second voltage to current converter and to set the selected voltage to a reference voltage indicative of the intermediate voltage for determining a reference value, to set the selected voltage to an input voltage for determining a first input value using the second voltage to current converter, to compare the reference value with the first input value, and to use the first input value as an accurate measurement when greater than or equal to the reference value.

In some embodiments, the first input value is greater than or equal to the reference value, the controller is configured to convert the first input value into the output voltage; and when the first input value is less than the reference value, the controller is configured to enable the first voltage to current converter, to set the selected voltage to the input voltage for determining a second input value using the first voltage to current converter, and to convert the second input value into the output voltage.

In some embodiments, the first voltage to current converter comprises a PMOS-type converter and wherein the second voltage to current converter comprises an NMOS-type converter.

In some embodiments, the converter comprises: a current to frequency converter that converts the output current to a frequency output; and a counter that converts the frequency output to a digital count code based on a reference clock.

In some embodiments, the first voltage to current converter is calibrated using second order curve fitting between the first voltage rail and the intermediate voltage for generating first gain parameters, and wherein the second voltage to current converter is calibrated using second order curve fitting between the intermediate voltage and the second voltage rail for generating second gain parameters.

In some embodiments, the converter is configured to convert the output current to a digital value; and wherein the controller is configured to retrieve the first gain parameters and to use the first gain parameters to convert the digital value to the output voltage when the first voltage to current converter is enabled, and to retrieve the second gain parameters and to use the second gain parameters to convert the digital value to the output voltage when the second voltage to current converter is enabled.

In some embodiments, calibration is performed at a plurality of temperatures in which the first and second gain parameters are each subdivided based on temperature; and wherein the controller is configured to receive a temperature value and to retrieve first or second gain parameters that correspond with the temperature value.

In a second aspect, there is provided a method for measuring a voltage between a first voltage rail and a second voltage rail, comprising: enabling a first voltage to current converter when a selected voltage is between the first voltage rail and an intermediate voltage that is between the first and second voltage rails; enabling a second voltage to current converter when the selected voltage is between the intermediate voltage and the second voltage rail; converting the output current into a corresponding measured value; and converting the measured value into an output voltage.

In some embodiments, the method further comprises: enabling the first voltage to current converter; setting the selected voltage to a reference voltage indicative of the intermediate voltage for determining a reference value; setting the selected voltage to an input voltage for determining a first input value using the first voltage to current converter; and comparing the reference value with the first input value for determining which one of the first and second voltage to current converters provides a more accurate measurement.

In some embodiments, when the first voltage to current converter is determined to provide a more accurate measurement, the converting comprises converting the first input value into the output voltage; and when the second voltage to current converter is determined to provide a more accurate measurement: enabling the second voltage to current converter; setting the selected voltage to the input voltage for determining a second input value using the second voltage to current converter; and wherein the converting comprises converting the second input value into the output voltage.

In some embodiments, the second voltage rail is greater than the first voltage rail, further comprising: enabling the second voltage to current converter; setting the selected voltage to a reference voltage indicative of the intermediate voltage for determining a reference value; setting the selected voltage to an input voltage for determining a first input value using the second voltage to current converter; comparing the reference value with the first input value; and using the first input value as an accurate measurement when greater than or equal to the reference value.

In some embodiments, when the first input value is greater than or equal to the reference value, the converting comprises converting the first input value into the output voltage; and when the first input value is less than the reference value: enabling the first voltage to current converter; setting the selected voltage to the input voltage for determining a second input value using the first voltage to current converter; and wherein the converting comprises converting the second input value into the output voltage.

In some embodiments, the enabling the first voltage to current converter comprises enabling a PMOS-type converter and wherein the enabling the second voltage to current converter comprises enabling an NMOS-type converter.

In some embodiments, the converting comprises: converting the output current to a frequency output; and converting the frequency output to a digital count code based on a reference clock.

In some embodiments, the method further comprises: calibrating the first voltage to current converter using second order curve fitting between the first voltage rail and the intermediate voltage for generating first gain parameters; and calibrating the second voltage to current converter using second order curve fitting between the intermediate voltage and the second voltage rail for generating second gain parameters.

In some embodiments, the converting comprises converting the output current to a digital value, further comprising: retrieving the first gain parameters and using the first gain parameters to convert the digital value to the output voltage when the first voltage to current converter is enabled; and retrieving the second gain parameters and using the second gain parameters to convert the digital value to the output voltage when the second voltage to current converter is enabled.

In some embodiments, the method further comprises: performing calibration at a plurality of temperatures and subdividing the first and second gain parameters based on temperature; receiving a temperature value; and wherein the retrieving comprises retrieving the first gain parameters or the second gain parameters that correspond with the received temperature value.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A voltage detector for measuring a voltage between a first voltage rail and a second voltage rail, comprising:
a first voltage to current converter configured to convert a selected voltage to an output current when enabled;
a second voltage to current converter configured to convert the selected voltage to the output current when enabled;
a converter that converts the output current into a corresponding measured value; and
a controller configured to enable the first voltage to current converter when the selected voltage is between the first voltage rail and an intermediate voltage that is between the first and second voltage rails, to enable the second voltage to current converter when the selected voltage is between the intermediate voltage and the second voltage rail, and to convert the measured value into an output voltage.

2. The voltage detector of claim 1, wherein the controller is configured to enable the first voltage to current converter and to set the selected voltage to a reference voltage indicative of the intermediate voltage for determining a reference value, to set the selected voltage to an input voltage for determining a first input value using the first voltage to current converter, and to compare the reference value with the first input value for determining which one of the first and second voltage to current converters provides a more accurate measurement.

3. The voltage detector of claim 2,
wherein when the first voltage to current converter is determined to provide a more accurate measurement, the controller is configured to convert the first input value into the output voltage; and
wherein when the second voltage to current converter is determined to provide a more accurate measurement, the controller is configured to enable the second voltage to current converter, to set the selected voltage to the input voltage for determining a second input value using the second voltage to current converter, and to convert the second input value into the output voltage.

4. The voltage detector of any preceding claim, wherein the second voltage rail is greater than the first voltage rail, and wherein the controller is configured to enable the second voltage to current converter and to set the selected voltage to a reference voltage indicative of the intermediate voltage for determining a reference value, to set the selected voltage to an input voltage for determining a first input value using the second voltage to current converter, to compare the reference value with the first input value, and to use the first input value as an accurate measurement when greater than or equal to the reference value.

5. The voltage detector of claim 4,
wherein when the first input value is greater than or equal to the reference value, the controller is configured to convert the first input value into the output voltage; and
when the first input value is less than the reference value, the controller is configured to enable the first voltage to current converter, to set the selected voltage to the input voltage for determining a second input value using the first voltage to current converter, and to convert the second input value into the output voltage.

6. The voltage detector of claim 5, wherein the first voltage to current converter comprises a PMOS-type converter and wherein the second voltage to current converter comprises an NMOS-type converter.

7. The voltage detector of any preceding claim, wherein the converter comprises:
a current to frequency converter that converts the output current to a frequency output; and
a counter that converts the frequency output to a digital count code based on a reference clock.

8. The voltage detector of any preceding claim, wherein the first voltage to current converter is calibrated using second order curve fitting between the first voltage rail and the intermediate voltage for generating first gain parameters, and wherein the second voltage to current converter is calibrated using second order curve fitting between the intermediate voltage and the second voltage rail for generating second gain parameters.

9. The voltage detector of claim 8,
wherein the converter is configured to convert the output current to a digital value; and
wherein the controller is configured to retrieve the first gain parameters and to use the first gain parameters to convert the digital value to the output voltage when the first voltage to current converter is enabled, and to retrieve the second gain parameters and to use the second gain parameters to convert the digital value to the output voltage when the second voltage to current converter is enabled.

10. The voltage detector of claim 9,
wherein calibration is performed at a plurality of temperatures in which the first and second gain parameters are each subdivided based on temperature; and
wherein the controller is configured to receive a temperature value and to retrieve first or second gain parameters that correspond with the temperature value.

11. A method for measuring a voltage between a first voltage rail and a second voltage rail, comprising:
enabling a first voltage to current converter when a selected voltage is between the first voltage rail and an intermediate voltage that is between the first and second voltage rails;
enabling a second voltage to current converter when the selected voltage is between the intermediate voltage and the second voltage rail;
converting the output current into a corresponding measured value; and
converting the measured value into an output voltage.

12. The method of claim 11, further comprising:
enabling the first voltage to current converter;
setting the selected voltage to a reference voltage indicative of the intermediate voltage for determining a reference value;
setting the selected voltage to an input voltage for determining a first input value using the first voltage to current converter; and
comparing the reference value with the first input value for determining which one of the first and second voltage to current converters provides a more accurate measurement.

13. The method of claim 12, wherein:
when the first voltage to current converter is determined to provide a more accurate measurement, the converting comprises converting the first input value into the output voltage; and
when the second voltage to current converter is determined to provide a more accurate measurement:
enabling the second voltage to current converter;
setting the selected voltage to the input voltage for determining a second input value using the second voltage to current converter; and
wherein the converting comprises converting the second input value into the output voltage.

14. The method of any of claims 11 to 13, wherein the second voltage rail is greater than the first voltage rail, further comprising:
enabling the second voltage to current converter;
setting the selected voltage to a reference voltage indicative of the intermediate voltage for determining a reference value;
setting the selected voltage to an input voltage for determining a first input value using the second voltage to current converter;
comparing the reference value with the first input value; and
using the first input value as an accurate measurement when greater than or equal to the reference value.

15. The method of claim 14, wherein:
when the first input value is greater than or equal to the reference value, the converting comprises converting the first input value into the output voltage; and
when the first input value is less than the reference value:
enabling the first voltage to current converter;
setting the selected voltage to the input voltage for determining a second input value using the first voltage to current converter; and
wherein the converting comprises converting the second input value into the output voltage.
